(19) Europäisches Patentamt
European Patent Office
Office européen des brevets

(11) **EP 2 201 681 B1**

(12) **FASCICULE DE BREVET EUROPEEN**

(45) Date de publication et mention
de la délivrance du brevet:
**23.02.2011 Bulletin 2011/08**

(21) Numéro de dépôt: **08805144.6**

(22) Date de dépôt: **08.10.2008**

(51) Int Cl.:
***H03H 9/02*** *(2006.01)*    ***H03H 3/007*** *(2006.01)*

(86) Numéro de dépôt international:
**PCT/EP2008/063468**

(87) Numéro de publication internationale:
**WO 2009/047266 (16.04.2009 Gazette 2009/16)**

(54) **COMPOSANT ELECTROMECANIQUE VIBRANT A L'ECHELLE NANOMETRIQUE OU MICROMETRIQUE A NIVEAU DE DETECTION AUGMENTE**

AUF NANOMETRISCHEM ODER MIKROMETRISCHEM MASSSTAB VIBRIERENDE ELEKTROMECHANISCHE KOMPONENTE MIT VERBESSERTEM DETEKTIONSNIVEAU

ELECTROMECHANICAL COMPONENT VIBRATING AT NANOMETRIC OR MICROMETRIC SCALE WITH ENHANCED DETECTION LEVEL

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **09.10.2007 FR 0758173**

(43) Date de publication de la demande:
**30.06.2010 Bulletin 2010/26**

(73) Titulaires:
• **Commissariat à l'Énergie Atomique
et aux Énergies Alternatives
75015 Paris (FR)**
• **STMicroelectronics SA
92120 Montrouge (FR)**

(72) Inventeurs:
• **CASSET, Fabrice
F-38570 Tencin (FR)**
• **DURAND, Cédric
F-38590 St Etienne De St Geoirs (FR)**

(74) Mandataire: **Ilgart, Jean-Christophe
BREVALEX
95 rue d'Amsterdam
75378 Paris Cedex 8 (FR)**

(56) Documents cités:
**FR-A- 2 872 501    FR-A- 2 906 238**

**Description**

**DOMAINE TECHNIQUE**

La présente invention est relative à un composant électromécanique, apte à vibrer, dimensionné à l'échelle nanométrique ou micrométrique. Ces composants électromécaniques, aptes à vibrer, englobent bien sûr les résonateurs mais encore les capteurs de mouvement, tels que les accéléromètres ou les capteurs de vibrations. Par la suite, de tels composants seront dénommés composants électromécaniques vibrants.

Le développement des appareils électroniques portables communicants de plus en petits et performants conduit à des études sur des composants électromécaniques vibrants et notamment des résonateurs électromécaniques de plus en plus petits. Les appareils électroniques portables communiquant sont par exemple des téléphones mobiles, des ordinateurs portables ou d'autres terminaux mobiles de communication. Ces résonateurs électromécaniques sont amenés à remplacer les résonateurs à quartz, ils sont généralement utilisés en tant que filtre ou horloge. Ces résonateurs électromécaniques se développent de plus en plus à cause de leurs performances théoriques et grâce au fait qu'on souhaite les intégrer.

Les capteurs de mouvement peuvent eux être utilisés dans des assistants numériques personnels et autres équipements portables fonctionnant sur batterie, dans les jouets, les équipements de production industrielle, la robotique et les systèmes automobiles. Ils peuvent aussi servir de capteurs de vibrations à usage général dans les équipements industriels et appareils électroménagers afin de détecter des défaillances avant l'apparition de symptômes perceptibles. Dans ces domaines également le souci de gagner en compacité sans perdre en performance existe.

**ÉTAT DE LA TECHNIQUE ANTÉRIEURE**

Les composants électromécaniques vibrants comportent sur un support un élément mécanique apte à vibrer. La vibration mécanique va générer un signal électrique qui sera détecté par une électrode de détection statique. Dans les résonateurs, l'élément mécanique vibrant présente une fréquence de résonance propre. Le résonateur rentre en résonance lorsqu'il est excité par un signal de d'excitation qui présente la même fréquence que la fréquence de résonance de l'élément mécanique vibrant. La fréquence de résonance s'exprime de la manière suivante :

$$\mathrm{fr} = \frac{1}{2\pi}\sqrt{\frac{kr}{m}} \qquad\qquad \text{équation 1}$$

avec m sa masse et kr sa rigidité mécanique.

Il existe plusieurs familles de composants électromécaniques vibrants parmi lesquelles celles dont l'élément mécanique vibrant est une poutre en flexion, un disque à mode elliptique ou de contour ou une plaque polygonale à mode de Lamé. Les fréquences s'expriment par :

Pour les poutres en flexion :

$$\mathrm{fr} = An\sqrt{\frac{E}{\rho}\frac{w}{L^2}} \qquad\qquad \text{Équation 2}$$

pour les disques à mode elliptique:

$$\mathrm{fr} = \frac{k}{2\pi R}\sqrt{\frac{E}{\rho(1-\upsilon^2)}} \qquad\qquad \text{Équation 3}$$

pour les plaques carrées à mode de Lamé :

$$\mathrm{fr} = \frac{1}{2L}\sqrt{\frac{Y_{2D}}{\rho}} \qquad\qquad \text{Équation 4}$$

An est un coefficient qui dépend du mode de vibration choisi et qui vaut 1,027 pour le mode fondamental, E est le module d'Young du matériau de la poutre, ρ est sa densité, w et L sont respectivement la largeur et la longueur de la poutre, R est le rayon du disque, ν est le coefficient de Poisson du disque et $Y_{2D}$ représente la rigidité mécanique de la plaque carrée.

Dans les capteurs de mouvement, l'élément mécanique se met à vibrer lors du mouvement et la vibration mécanique si elle correspond à la fréquence de résonance de l'élément mécanique est détectée à l'aide de l'électrode de détection, cette dernière délivrant le signal électrique à la fréquence de la vibration de l'élément mécanique.

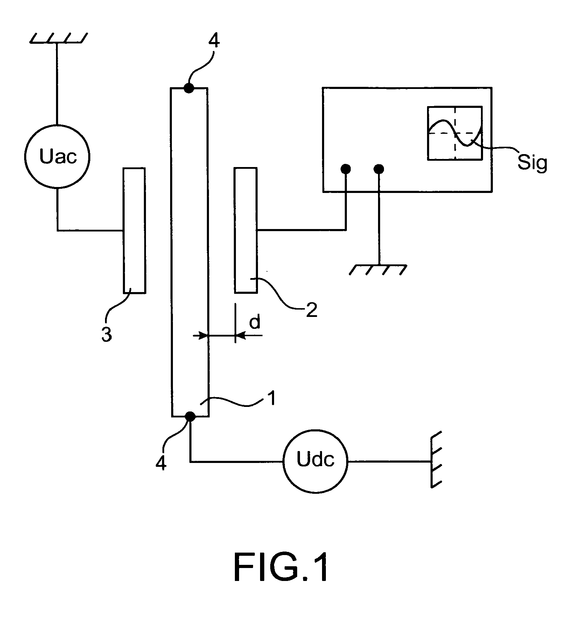

La grande majorité de ces composants électromécaniques vibrants possèdent une détection capacitive. La figure 1 donne schématiquement, en vue de dessus, la configuration d'un composant électromécanique vibrant tel qu'un résonateur. Il comporte un élément mécanique 1 apte à vibrer, et localisé à proximité au moins une électrode 2 fixe. Lors de la vibration, l'élément mécanique 1 vibrant présente une déformation dans le plan de la feuille. L'élément mécanique 1 est représenté comme une poutre ayant un point d'ancrage 4 à chacune de ses extrémités.

L'élément mécanique 1 est polarisé à une tension Udc. Dans l'exemple décrit, on a prévu une électrode d'actionnement 3, disposée telle que l'élément mécanique 1 soit placé entre elle et l'autre électrode 2 dite de détection. Les deux électrodes 2, 3 sont en vis-à-vis, elles sont statiques. Un signal radiofréquence Uac est appliqué à l'électrode d'actionnement 3, si ce signal radiofréquence présente une fréquence égale à la fréquence de résonance de l'élément mécanique 1, celui-ci se met à vibrer à sa fréquence de résonance et est soumis à un maximum de déplacement. En vibrant l'élément mécanique 1 se déplace et son mouvement fait qu'il va alternativement se rapprocher et s'éloigner de l'électrode de détection 2. Une variation de capacité modulée à la fréquence de l'élément mécanique vibrant va prendre naissance.

A la résonance, l'électrode de détection 2 détecte un signal Sig dont la fréquence est la fréquence de résonance de l'élément mécanique 1. Si l'élément mécanique 1 ne vibre pas à sa fréquence de résonance, l'électrode de détection 2 ne délivre aucun signal. Dans certaines configurations, il y a une unique électrode qui sert à la fois pour l'actionnement et pour la détection. L'électrode de détection 2 et l'élément mécanique vibrant 1 sont espacés d'une distance d au repos. Sur la figure 1, la déformation de l'élément mécanique vibrant n'est pas visible.

Les composants électromécaniques vibrants comme ceux que l'on vient de décrire sont caractérisés par une fréquence de résonance fr, un facteur de qualité Q qui traduit leur capacité à restituer l'énergie d'excitation lors de sa mise en vibration et une résistance motionnelle Rm qui est fonction de la distance minimum d à la puissance 4 entre électrode et élément mécanique vibrant. Cette résistance motionnelle Rm est inversement proportionnelle au facteur de qualité Q. Elle modélise les pertes dissipatives du composant électromécanique. Le facteur de qualité Q dépend du mode de vibration choisi pour l'élément mécanique vibrant et des pertes mécaniques liées au mode de fixation de l'élément mécanique vibrant. La fréquence de résonance de l'élément mécanique vibrant dépend de ses dimensions. Dans les composants électromécaniques vibrants à l'échelle micrométrique et nanométrique, l'élément mécanique vibrant est délimité par photolithographie. Il est donc possible de prévoir, avec le même procédé de fabrication, des éléments mécaniques vibrants de plusieurs dimensions pour pouvoir bénéficier d'autant de fréquences de résonance.

Les poutres en flexion peuvent présenter une vibration dans le plan (plan principal de la poutre) ou hors plan comme indiqué dans le document [1] et le document [2] respectivement dont les références complètes sont précisées à la fin de la description. Elles ont des fréquences limitées à quelques dizaines de MHz pour conserver des performances permettant une utilisation industrielle. On peut citer par exemple le résonateur à poutre de la société Discera dont la fréquence est de 10 MHz et le facteur de qualité Q vaut 4000.

Les résonateurs à disque ou plaque polygonale présentent un déplacement dans le plan du disque ou de la plaque. Ils permettent d'atteindre des fréquences de résonance beaucoup plus importantes tout en conservant un facteur de qualité Q élevé. On peut citer par exemple des résonateurs disques de l'Université du Michigan dont la fréquence de résonance est de 1,51 GHz comme décrit dans le document [3].

Ainsi pour couvrir une gamme de fréquences la plus large possible et pour obtenir la plus grande variété possible de composants électromécaniques vibrants avec le même procédé de fabrication, il est préférable d'utiliser des éléments mécaniques vibrants présentant un déplacement dans le plan.

Pour obtenir un facteur de qualité Q aussi grand que possible, il faut utiliser des distances entre électrode et élément vibrant aussi petites que possible en fonctionnement car ainsi la résistance motionnelle est petite. Beaucoup de signal est récupéré par l'électrode de détection.

Les composants électromécaniques à l'échelle micrométrique existants ont un élément mécanique vibrant présentent bien souvent une épaisseur importante de l'ordre de quelques micromètres voire de la dizaine de micromètres. Par exemple les plaques polygonales et les poutres de la société VTT ont une épaisseur de 10 micromètres et une fréquence de résonance de 13,1 MHz, les disques de l'Université du Michigan ont une épaisseur de 3 micromètres pour une fréquence de résonance de 1,51 GHz et les disques de l'Institut Technologique de Georgia ont une épaisseur de 18 micromètres pour une fréquence de résonance de 149,3 MHz. Ces éléments mécaniques vibrants ont un gros volume, ce qui leur permet d'emmagasiner suffisamment d'énergie pour présenter un fort facteur de qualité. Mais leur inconvénient est qu'ils sont difficilement intégrables au niveau de composants actifs tels que des transistors. Ils posent des problèmes lors des étapes technologiques qui suivent la délimitation de l'élément mécanique vibrant. Les étapes de lithographie sont difficilement réalisables car on perd le contrôle dimensionnel. Actuellement ils sont généralement utilisés seuls ou vendus encapsulés en tant que module.

En plus de diminuer leur épaisseur, on cherche à diminuer leurs dimensions latérales pour les rendre plus compacts, la diminution de l'encombrement étant un objectif constant de nos jours. Si seule l'épaisseur de l'élément mécanique vibrant est diminuée sans diminuer ses autres dimensions, ce dernier possédera une rigidité mécanique trop faible.

Un autre objectif actuel est de monter en fréquence de résonance, puisque la fréquence varie de manière inversement proportionnelle aux dimensions, cela conduit à réduire l'élément mécanique vibrant dans toutes ses dimensions.

La diminution de la taille du composant électromécanique vibrant et plus particulièrement de son élément mécanique vibrant va directement engendrer des capacités de plus en plus petites à mesurer, car les surfaces d'électrodes en regard seront aussi de plus en plus petites. En dessous d'une certaine taille, la détection capacitive ne peut plus se faire. Par exemple une poutre en flexion dans le plan avec une longueur L de 10 micromètres, une largeur w de 0,46 micromètres et une épaisseur h de l'ordre de quelques dizaines de nanomètres voire de quelques micromètres, aura une déformation d'environ 10 à 15 nanomètres à la résonance. Si la valeur de l'espacement au repos entre l'électrode de détection et l'élément mécanique vibrant est de l'ordre de 80 nanomètres, ce qui correspond à une valeur classique, la variation de la capacité à mesurer sera seulement de quelques ato Farad ($10^{-18}$ Farad) pour une épaisseur d'environ 400 nm de l'élément mécanique vibrant. On arrive alors aux limites de sensibilité des appareillages de mesure.

Le document FR 2 872 501 décrit un résonateur électromécanique comprenant un corps vibrant, une électrode d'excitation et une électrode de détection.

## EXPOSÉ DE L'INVENTION

La présente invention a justement comme but de proposer un composant électromécanique vibrant à l'échelle micrométrique ou nanométrique qui ne présente pas les inconvénients mentionnés ci dessus.

Un but est en particulier de proposer un composant électromécanique vibrant à l'échelle micrométrique ou nanométrique ayant une épaisseur réduite de manière à pouvoir être intégré sans rencontrer de problème de détection à la résonance.

Un autre but de l'invention est de proposer un composant électromécanique vibrant à l'échelle micrométrique ou nanométrique possédant un facteur de qualité, un rapport signal sur bruit aussi grands que possible et une résistance motionnelle aussi petite que possible.

Encore un autre but de l'invention est de proposer un composant électromécanique vibrant à l'échelle micrométrique ou nanométrique aussi compact que possible.

Un but supplémentaire de l'invention est de proposer un composant électromécanique vibrant à l'échelle micrométrique ou nanométrique ayant une fréquence de résonance accrue.

Pour atteindre ces buts, l'invention propose de rendre mobile l'électrode qui sert à la détection.

L'invention concerne plus précisément un composant électromécanique vibrant à l'échelle nanométrique ou micrométrique, comportant un élément mécanique vibrant qui coopère avec au moins une électrode dite de détection. L'électrode de détection est souple et est destinée à vibrer en opposition de phase par rapport à l'élément mécanique vibrant.

Le composant électromécanique vibrant peut comporter en outre au moins une électrode d'actionnement qui coopère avec l'élément mécanique vibrant.

Dans une configuration particulièrement compacte, l'électrode d'actionnement peut être confondue avec l'électrode de détection.

On place de préférence l'électrode d'actionnement et l'électrode de détection face à face de part et d'autre de l'élément mécanique vibrant.

Lorsque le composant électromécanique comporte plusieurs électrodes souples, on les place préférentiellement face à un ventre de vibration d'au moins un mode de vibration de l'élément mécanique vibrant.

Lorsqu'il y a plusieurs électrodes souples, l'une au moins peut vibrer sur un mode harmonique de l'élément mécanique vibrant, au moins une autre vibrant sur un autre mode harmonique ou sur le mode fondamental de l'élément mécanique vibrant.

L'électrode souple peut être une poutre fonctionnant en flexion.

L'élément mécanique vibrant peut être également une poutre fonctionnant en flexion.

La poutre de l'élément mécanique vibrant peut être ancrée à ses extrémités ou dans sa partie médiane.

En variante, l'élément mécanique vibrant peut être un disque à mode elliptique ou une plaque polygonale de Lamé.

On peut donner à l'électrode souple une longueur inférieure ou égale à celle de l'élément mécanique vibrant.

Il est préférable que l'élément mécanique vibrant ait une rigidité mécanique sensiblement égale à celle de l'électrode souple de manière à optimiser le fonctionnement du composant électromécanique vibrant.

Le composant électromécanique vibrant peut être un résonateur ou un capteur de mouvement tel qu'un accéléromètre ou un capteur de vibrations.

La présente invention concerne également un procédé de réalisation d'un composant électromécanique vibrant à l'échelle nanométrique ou micrométrique comportant un élément mécanique vibrant qui coopère avec au moins une électrode dite de détection qui est souple et est destinée à vibrer en opposition de phase par rapport à l'élément mécanique vibrant, comportant les étapes suivantes :

a) formation sur un substrat de matériau semi-conducteur d'un caisson limité par du matériau diélectrique au contour d'une zone active englobant en partie l'élément mécanique vibrant et l'électrode souple,

b) remplissage du caisson d'un matériau sacrificiel, puis d'un matériau semi-conducteur dopé qui déborde hors du caisson pour former l'élément mécanique vibrant et l'électrode souple,

c) gravure d'au moins une ouverture dans le matériau semi-conducteur dopé atteignant le matériau sacrificiel pour former un espacement entre l'élément mécanique vibrant et l'électrode souple et pour délimiter l'électrode souple d'un support de l'électrode souple.

d) élimination du matériau sacrificiel par l'ouverture,

e) couverture par un matériau de protection du composant électromécanique à l'exception de la zone active,

f) réalisation d'au moins un contact électrique sur l'électrode souple en dehors de la zone active à travers le matériau de protection.

Lorsque le composant électromécanique comporte au moins une autre électrode qui est rigide, la zone active englobe en partie l'électrode rigide, le matériau semi-conducteur dopé remplissant le caisson et débordant hors du caisson réalise l'électrode rigide à l'étape b), une ouverture dans le matériau semi-conducteur dopé est réalisée pour former un espacement entre l'électrode rigide et l'élément mécanique vibrant à l'étape c), un contact électrique est réalisé sur l'électrique rigide en dehors de la zone active à travers le matériau de protection à l'étape f).

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

la figure 1 montre schématiquement un composant électromécanique vibrant de l'art antérieur ;

la figure 2 illustre le principe du couplage capacitif entre un élément conducteur entraîné en vibration placé à proximité d'un autre élément conducteur pouvant vibrer ;

les figures 3A, 3B sont des vues de dessus d'exemples de composants électromécaniques vibrants de l'art antérieur et de l'invention ;

les figures 4A, 4B sont des exemples de composants électromécaniques vibrants, objets de l'invention, en fonctionnement ;

les figures 5A, 5B sont des simulations illustrant les déformations d'un composant électromécanique vibrant selon l'invention vibrant sur l'harmonique 2 et sur l'harmonique 3 ;

les figures 6A, 6B, 6C illustrent d'autres exemples de composants électromécaniques vibrants selon l'invention ;

les figures 7A à 7J illustrent différentes étapes d'un procédé de réalisation d'un composant électromécanique vibrant selon l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

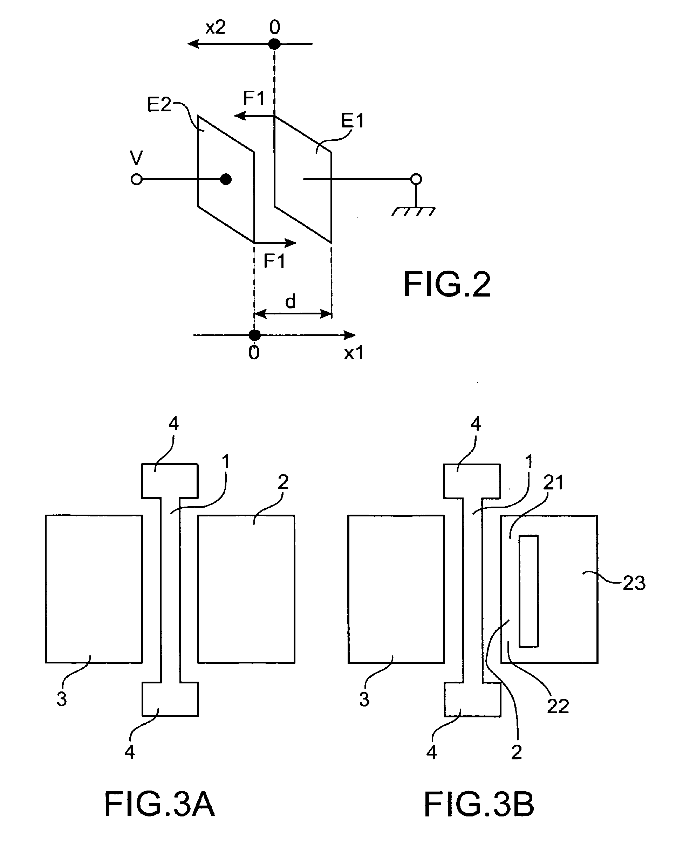

On va maintenant se référer aux figures 3A, 3B qui montrent de manière schématique, en vue de dessus, un composant électromécanique vibrant de l'art antérieur et selon l'invention.

On suppose que dans ces exemples, l'élément mécanique vibrant 1 est une poutre ancrée à ses deux extrémités et qu'il y a une électrode d'actionnement 3 et une électrode de détection 2, placées face à face, avec la poutre 1 entre elles. Sur la figure 3A, les deux électrodes 2, 3 sont identiques et rigides. Sur la figure 3B, l'électrode d'actionnement 3 est rigide mais pas l'électrode de détection 2. L'électrode de détection 2 est souple, elle peut prendre par exemple la forme d'une poutre apte à se déformer en flexion. Dans l'exemple décrit, elle est ancrée à ses deux extrémités référencées 21, 22 qui sont solidaires d'un support 23. Pour que l'électrode de détection 2 puisse être aussi efficace que possible, on part du fait que l'élément mécanique vibrant 1 doit avoir la plus grande amplitude de vibration possible, afin d'engendrer au niveau de l'électrode de détection 2 la plus grande variation de capacité possible. Pour que l'élément mécanique vibrant 1 ait donc la plus grande amplitude possible, pour une excitation donnée, il est possible de diminuer sa rigidité mécanique. Cette solution n'est pas satisfaisante car la fréquence de résonance de l'élément mécanique vibrant va alors diminuer et cela n'est pas souhaitable.

En fait l'invention repose sur le principe du couplage capacitif entre un élément conducteur E1 entraîné en vibration placé à proximité d'un autre élément conducteur E2 pouvant vibrer. On se réfère à la figure 2 qui illustre ce principe. En vibrant le premier élément conducteur E1 est soumis à une force alternative F1. La vibration du premier élément E1 conducteur va engendrer une force électrostatique alternative F2 sur le second élément E2 conducteur qui va s'apparenter à une rigidité négative. Cette rigidité de couplage s'exprime par $k_{12}= -V^2 \varepsilon_0 S/d^3$ avec V tension appliquée sur le premier élément E1 pour le faire vibrer, S surfaces des deux éléments en regard, d espacement entre le premier élément conducteur E1 et le second élément conducteur E2, $\varepsilon_0$ est la permittivité du vide. Ce principe est connu dans la littérature concernant les résonateurs électromécaniques comme par exemple dans le document [4]. Les forces F1, F2 qui s'appliquent sur le premier élément E1 et sur le second élément E2 s'expriment respectivement par F1= $-k_{12}(x1 + x2)$ et F2= $k_{12}(x2 + x1)$, x1 et x2 représentent les déformations à la résonance du premier élément E1 et du second élément E2.

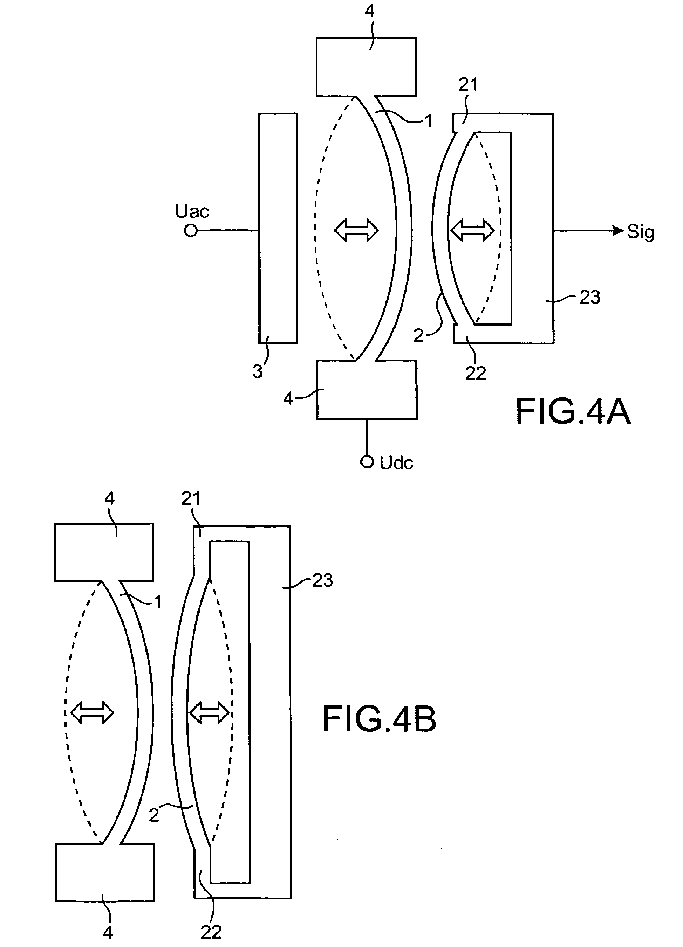

Pour obtenir une variation de capacité la plus grande possible dans le composant électromécanique vibrant, l'idée est donc de coupler de manière électrostatique l'élément mécanique vibrant 1 et l'électrode de détection 2 et de faire se déplacer l'électrode de détection 2 en opposition de phase avec l'élément mécanique vibrant 1. Sur les figures 3A, 3B, les composants électromécaniques vibrants sont au repos. On a représenté sur les figures 4A, 4B des vues schématiques de composants électromécaniques vibrants conformes à l'invention en fonctionnement. En traits pleins, on a représenté l'électrode souple 2 et l'élément mécanique vibrant 1 en position la plus proche et les pointillés illustrent l'électrode souple 2 et l'élément mécanique vibrant 1 en position la plus éloignée. Lors du couplage électrostatique, l'électrode souple 2 vibre sur son mode fondamental. Dans l'exemple des figures 4A, 4B, on suppose que l'élément mécanique vibrant 1 vibre dans le plan.

Avec une électrode souple 2 et un élément mécanique vibrant 1 en opposition de phase, on obtiendra donc la plus grande variation de capacité possible. Avec une telle configuration, le rapport signal sur bruit va augmenter significativement. De plus, en position la plus proche, l'espacement minimum entre l'élément mécanique vibrant 1 et l'électrode souple 2 pourra être réduit ce qui permet de réduire la résistance motionnelle et d'augmenter le facteur de qualité.

Sur les figures 4A, 4B l'élément mécanique vibrant 1 vibre en mode fondamental. Il en est de même pour l'électrode souple 2. On dispose l'électrode souple 2 de manière à ce qu'elle soit face à une zone de vibration à amplitude maximale de l'élément mécanique vibrant 1, ce qui correspond à un ventre de vibration.

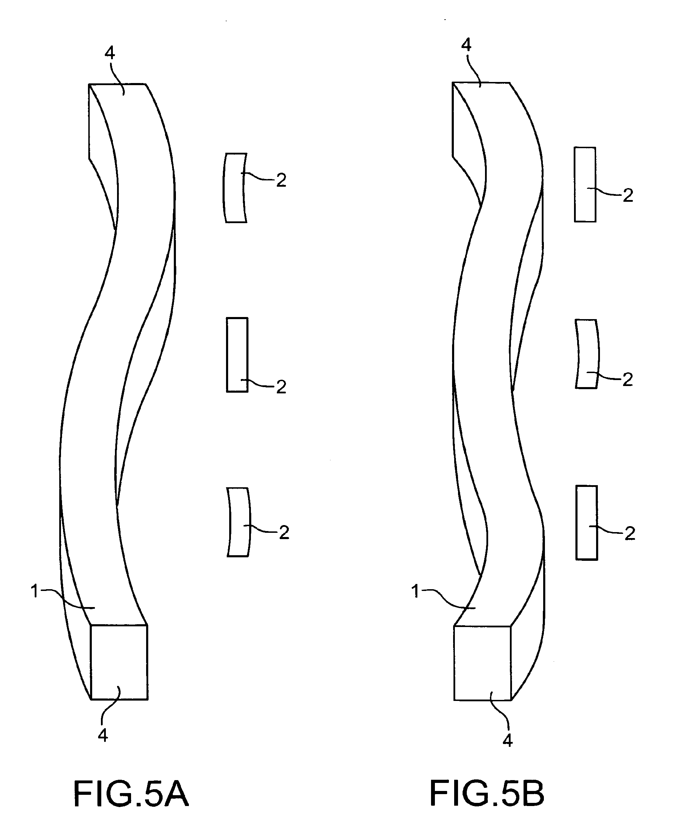

Il est bien sûr possible que l'élément mécanique vibrant 1 vibre sur un mode harmonique d'ordre 2, 3 ou plus comme illustré sur les figures 5A, 5B. Ces figures représentent des simulations de vibrations d'un élément mécanique vibrant de type poutre ancrée à ses deux extrémités. Sur la figure 5A, la vibration correspond à l'harmonique 2 et sur la figure 5B, elle correspond à l'harmonique 3. Il y a plusieurs ventres de vibrations. Il y a plusieurs positions possibles pour l'électrode souple 2, et d'ailleurs, on peut prévoir de disposer plusieurs électrodes souples 2 et d'utiliser pour chaque mode de vibration donné seulement celle ou celles correspondant à ce mode. Les électrodes souples 2 peuvent être utilisées simultanément si elles sont placées, pour un mode harmonique donné, face à un ventre de vibration, ou séparément, chacune pouvant être placée face à un ventre de vibration dans un mode harmonique donné. Sur les figures 5A, 5B on a disposé trois électrodes souples 2 qui se suivent le long de la poutre matérialisant l'élément mécanique vibrant 1. Sur la figures 5A, les deux électrodes souples 2 extrêmes sont utilisées simultanément, l'électrode souple centrale ne servant pas puisqu'elle est face à un noeud de vibration de l'élément mécanique vibrant 1. C'est l'inverse qui se produit sur la figure 5B. Sur ces figures, l'élément mécanique vibrant 1 en forme de poutre possède une longueur de 10 micromètres et une largeur de 0,46 micromètres. La fréquence de résonance est de 106 MHz pour l'harmonique 2 et de 206 MHz pour l'harmonique 3. Bien sûr, comme dans l'art antérieur, l'électrode souple est dimensionnée pour qu'elle présente une fréquence de résonance égale à celle de l'élément mécanique vibrant. Selon l'harmonique de vibration choisie, la fréquence de résonance ne sera pas la même et les différentes électrodes devant travailler sur des modes harmoniques différents n'auront pas les mêmes dimensions comme illustré sur les figures 5A, 5B.

La relation qui lie la fréquence de résonance fr au mode de vibration et aux dimensions de l'électrode souple correspond à l'équation 2.

Sur la figure 4A et les figures 5A, 5B, l'électrode souple 2 en forme de poutre est plus courte que l'élément mécanique vibrant 1 lui-même en forme de poutre. Il est bien sûr possible que l'électrode souple 2 et l'élément mécanique vibrant 1 aient sensiblement la même longueur comme illustré sur la figure 4B. Elle pourrait également être plus longue que l'élément mécanique vibrant, mais cette configuration est moins intéressante dans un souci de compacité.

Sur les figures 4A, 4B, on suppose que l'électrode souple 2 sert à la fois à la détection et à l'actionnement.

Dans un composant électromécanique vibrant donné, les rôles des électrodes peuvent changer selon le mode d'utilisation du composant. L'article référencé [5] décrit plusieurs méthodes de caractérisations de résonateurs microélectroniques avec plusieurs électrodes qui peuvent avoir des rôles différents selon les modes excités de l'élément mécanique vibrant.

Le principe de fonctionnement du composant électromécanique vibrant selon l'invention est le même que dans l'art antérieur. On va le décrire rapidement pour un résonateur en se référant à la figure 4A. On polarise l'élément mécanique vibrant 1 à la tension Udc.

On applique une tension radio fréquence Uac d'excitation à l'électrode d'actionnement 3. Cette dernière peut être une électrode rigide dédiée à l'actionnement comme sur la figure 4A ou bien l'électrode souple qui sert également de détection. La tension radiofréquence Uac induit une force alternative dans l'élément mécanique vibrant 1. Ce dernier va entrer en vibration. Sa vibration va induire une modification de champ électrique entre lui-même et l'électrode souple 2. Une force alternative va prendre naissance sur l'électrode souple 2 due au couplage électrostatique, elle va induire une vibration de l'électrode souple 2 au rythme de la vibration de l'élément mécanique vibrant 1 mais en opposition de phase avec lui. Le couplage électrostatique se comporte comme une rigidité négative comme on l'a vu plus haut.

Lorsque la tension radiofréquence Uac présente une fréquence égale à la fréquence de résonance de l'élément mécanique vibrant 1, il entre en résonance et présente une amplitude de déplacement maximale. Lorsque le couplage électrostatique induit une fréquence d'excitation de l'électrode souple 2 équivalente à sa fréquence de résonance, l'électrode souple présente une amplitude de déplacement maximale. Le signal Sig « passe », il est délivré par l'électrode souple 2. Aux autres fréquences l'électrode souple 2 ne délivre pas de signal.

Le rapport signal sur bruit du composant électromécanique vibrant dépend de la différence de capacité entre la position dans laquelle l'élément mécanique vibrant 1 et l'électrode souple 2 sont au plus près et la position dans laquelle l'élément mécanique vibrant 1 et l'électrode souple 2 sont au plus loin. Avec l'utilisation de l'électrode souple 2 qui se déforme, on accroît la différence de capacité entre l'état de l'élément mécanique vibrant 1 proche de l'électrode souple 2 et l'état de l'élément mécanique vibrant 1 éloigné de l'électrode souple 2.

Lors d'une simulation avec le logiciel Coventor qui est un logiciel de simulation basé sur la méthode de calcul par éléments finis, des déplacements de l'élément mécanique vibrant et de l'électrode souple d'un composant électromécanique vibrant similaire à celui représenté aux figures 5 mais fonctionnant en mode fondamental ont été mesurés. L'espacement au repos entre l'élément mécanique vibrant et l'électrode souple est de 80 nanomètres. L'amplitude de déformation de l'élément mécanique vibrant et de l'électrode souple est d'environ 15 nanomètres. En fonctionnement l'espacement minimal entre l'électrode souple et l'élément mécanique vibrant est de l'ordre de 50 nanomètres ce qui est environ 20 % inférieur à l'espacement minimal obtenu dans l'art antérieur qui était de l'ordre de 65 nanomètres. Cette diminution d'espacement minimum conduit à une augmentation de la variation de la capacité puisque ces deux grandeurs sont inversement proportionnelles.

La résistance motionnelle du composant électromécanique vibrant est proportionnelle à l'espacement minimal do à la puissance 4 comme le montre l'équation 5 suivante qui exprime la résistance motionnelle du composant électromécanique vibrant dans l'air. Le facteur de qualité Q est inversement proportionnel à l'espacement minimal do à la puissance 4.

$$ R = \frac{kr}{\omega_0 Udc^2} \times \frac{do^4}{\varepsilon_0^2 \varepsilon_r^2 S^2} \times \frac{1}{Q} \qquad \text{Équation 5} $$

Avec $\omega_0$ pulsation, Udc tension de polarisation, do espacement au repos entre électrode souple et élément électromécanique vibrant, kr est la rigidité mécanique de l'élément mécanique vibrant, $\varepsilon_0$ est la permittivité du vide et $\varepsilon_r$ est la permittivité de l'air, S représente la surface en regard de l'élément mécanique vibrant et de l'électrode souple, Q est le facteur de qualité du composant électromécanique vibrant.

Il est donc possible d'améliorer le facteur de qualité Q de plusieurs dizaines de pourcents.

Le composant électromécanique vibrant selon l'invention avec un élément mécanique vibrant donné possède une fréquence de résonance qui n'est pas modifiée par rapport à un composant électromécanique vibrant de l'art antérieur possédant le même élément mécanique vibrant. Par contre le rapport signal sur bruit du composant électromécanique vibrant de l'invention sera augmenté de manière significative, à priori du même ordre de grandeur que l'augmentation de la variation de capacité c'est-à-dire de la diminution de l'espacement minimum.

Pour un bon fonctionnement du composant électromécanique vibrant selon l'invention, il est préférable que la rigidité mécanique kr de l'élément mécanique vibrant soit sensiblement égale à celle de l'électrode souple. La rigidité mécanique de l'électrode souple dépend de ses dimensions, elle est notée k.

Dans ce cas les fréquences de résonance de l'élément mécanique vibrant et de l'électrode souple seront sensiblement égales. La fréquence de résonance du composant électromécanique vibrant sera donnée par :

$$fr = \frac{1}{2\pi}\sqrt{\frac{k+k_{12}}{m}}$$

L'électrode souple et l'élément mécanique vibrant auront sensiblement la même amplitude de déplacement mais ces déplacements seront en opposition de phase.

Si l'électrode souple et l'élément mécanique vibrant présentent la même longueur comme illustré sur la figure 4B, les surfaces en regard seront maximisées. La largeur w de l'électrode souple pourra être choisie en appliquant l'équation 2 afin que les fréquences de résonance soient les mêmes pour l'électrode souple et l'élément mécanique vibrant.

Comme on l'a vu précédemment sur les figures 4A et 5, il n'est pas nécessaire que l'électrode souple ait la même longueur que l'élément mécanique vibrant. Il est toutefois possible de trouver un ou plusieurs couples longueur-largeur pour l'électrode souple qui conduisent à l'égalité des fréquences de résonance. Le fait de réduire la longueur de l'électrode souple, tout en la plaçant face à un ventre de vibration de l'élément mécanique vibrant permet de réduire la capacité statique initiale, puisque la réduction de la longueur entraîne aussi une réduction de la largeur. Par exemple une poutre de 10 micromètres par 0,46 micromètre présentera une fréquence de résonance de 38,8 MHz et une poutre de 6 micromètres par 0,166 micromètre présentera la même fréquence de résonance.

En conclusion, on peut être amené à positionner une ou plusieurs électrodes souples le long d'un élément mécanique vibrant de type poutre. S'il y a une seule électrode, elle peut avoir les mêmes dimensions surfaciques que l'élément mécanique vibrant. S'il y en a plusieurs elles auront des dimensions surfaciques différentes. Mais on donnera aux électrodes une rigidité mécanique sensiblement égale à celle de l'élément mécanique vibrant. Par ce biais, la détection du signal est optimisée, quel que soit le mode de fonctionnement de l'élément mécanique vibrant.

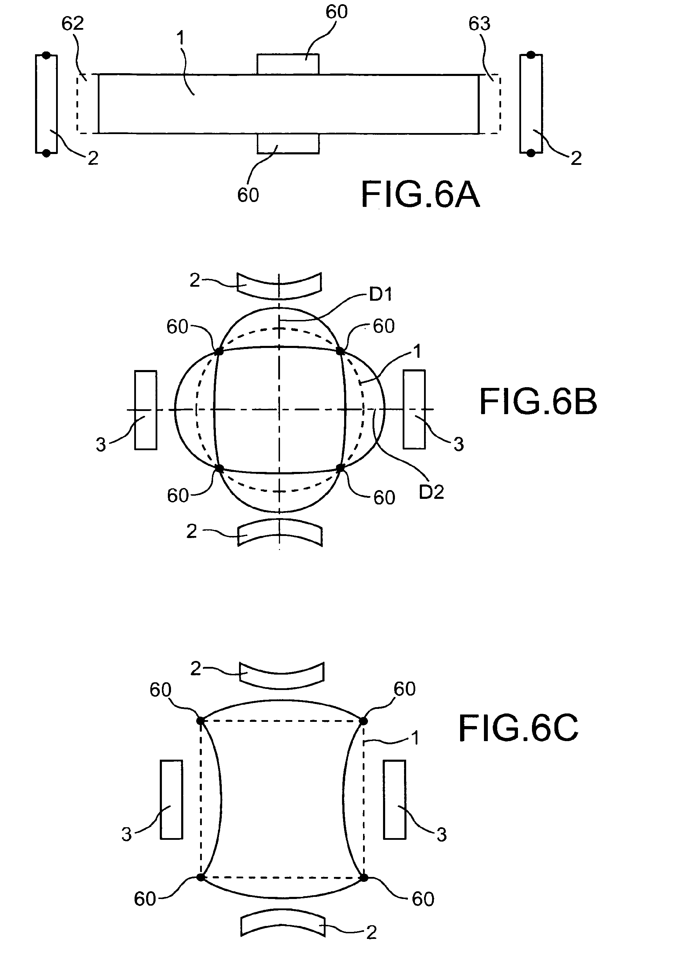

La présente invention s'applique également aux éléments mécaniques vibrants de type poutre à ancrage central comme illustré sur les figures 6A, 6B, 6C. Sur la figure 6A, l'élément mécanique vibrant 1 est une poutre ancrée dans sa partie médiane. L'ancrage est référencé 60. Il y a une électrode souple 2 disposée face à chacune des ses extrémités 62, 63. Les électrodes souples 2 sont des poutres ancrées à leurs extrémités. Les parties en pointillés 61 aux extrémités 62, 63 de l'élément mécanique vibrant 1 illustrent un aperçu de l'allongement de l'élément mécanique vibrant à la résonance, c'est-à-dire d'un ventre de vibration. Les électrodes souples 2 font face à ces parties résultant de l'allongement. Sur la figure 6A, les électrodes souples 2 servent en même temps d'électrode d'actionnement et d'électrodes d'excitation.

Sur la figure 6B, l'élément mécanique vibrant 1 est un disque vibrant sur un mode elliptique. Il possède quatre points d'ancrage 60. On pourrait envisager qu'il en comporte moins, un seul suffirait. Ces points d'ancrages 60 sont diamétralement opposés deux à deux. L'élément mécanique vibrant 1 est représenté en traits pleins, déformé dans ses deux positions extrêmes et en traits pointillés, au repos. Les points d'ancrage 60 sont placés de telle sorte que les déformations maximales du disque conduisent à deux ellipses ayant des grands axes référencés D1, D2.

On a représenté quatre électrodes agencées par paires, deux électrodes d'une paire se faisant face. Les deux paires sont décalées de sensiblement 90°. Chaque électrode 2, 3 est sensiblement perpendiculaire à un grand axe D1, D2 de l'une des ellipses. On suppose que les électrodes 3 d'une paire sont rigides, ce sont des électrodes d'actionnement et elle sont situées sensiblement perpendiculaires au grand axe D2.

Les électrodes 2 de l'autre paire sont souples, elles sont situées sensiblement perpendiculaires au grand axe D1.

La figure 6C illustre le cas où l'élément mécanique vibrant est une plaque sensiblement carrée qui utilise un mode de vibration dit de Lamé. Les points d'ancrage référencés 60 se trouvent dans les coins de la plaque. La plaque est délimitée par des pointillés. Ici encore, on pourrait avoir moins de quatre points d'ancrage, un seul suffit. En traits pleins, on a représenté la plaque dans une de ses positions déformées, avec une déformation maximum. De la même manière que précédemment, il y a quatre électrodes regroupées en deux paires, les électrodes d'une paire se font face. Les électrodes d'une paire sont des électrodes d'actionnement 3, elles sont rigides. Les électrodes de l'autre paire sont des électrodes de détection souples 2. Les électrodes sont sensiblement parallèles aux côtés de la plaque carrée. Les électrodes souples 2 sont face aux ventres de vibration de la plaque carrée.

On va maintenant décrire un procédé de fabrication d'un composant électromécanique vibrant selon l'invention. On suppose qu'il comporte une électrode souple et au moins une électrode rigide de part et d'autre d'un élément mécanique vibrant.

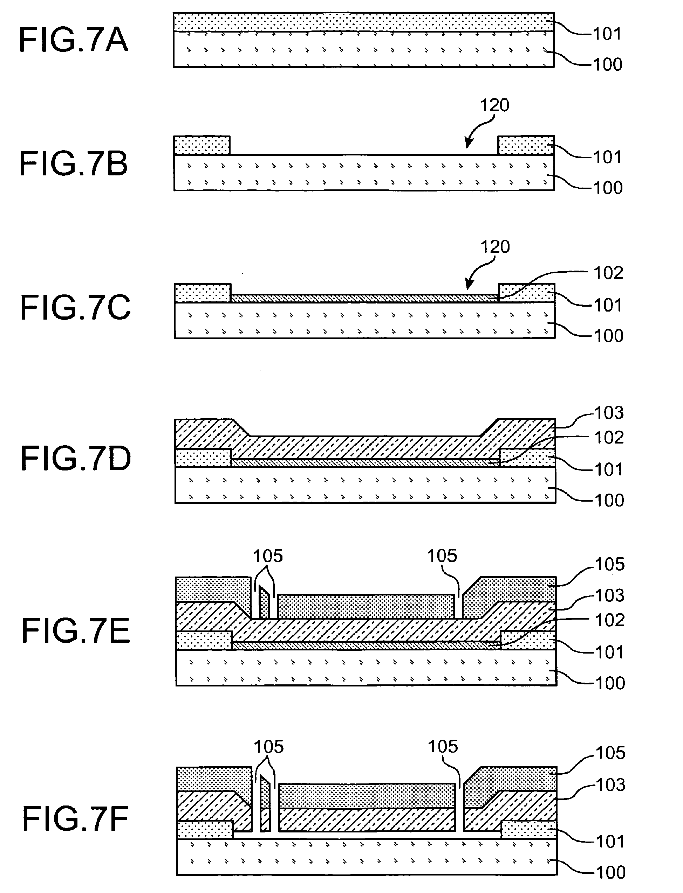

On part d'un substrat 100 semi-conducteur par exemple de silicium sur lequel on forme une couche superficielle de matériau diélectrique, par exemple de l'oxyde de silicium (figure 7A). La couche d'oxyde superficielle porte la référence 101. Elle peut avoir une épaisseur comprise entre environ 200 et 500 nanomètres. L'oxydation peut être une oxydation thermique.

Par une opération de photolithographie et gravure (figure 7B), on va réaliser un caisson 120 délimité latéralement par la couche 101 et dont le fond met à nu le substrat 100. Sa surface correspond à celle d'une zone active du composant électromécanique vibrant c'est-à-dire une zone de l'élément mécanique vibrant amené à se déplacer et une zone de chaque électrode située en vis-à-vis de l'élément mécanique vibrant. Cette zone active sera suspendue lorsque le composant électromécanique vibrant sera achevé. Cette gravure est par exemple de type plasma.

On place (figure 7C) au fond du caisson 120 par exemple par épitaxie sélective, une couche sacrificielle 102. La couche sacrificielle recouvre le substrat 100 mis à nu. Le matériau de la couche sacrificielle 102 peut être par exemple du SiGe. La couche sacrificielle 102 peut avoir une épaisseur comprise entre environ 20 à 80 nanomètres.

On forme par exemple par épitaxie (figure 7D) une couche 103 de matériau semi-conducteur. Cette couche 103 remplit le caisson 120 et déborde autour. Elle va servir à former le composant électromécanique vibrant de l'invention, c'est-à-dire l'élément mécanique vibrant, et les deux électrodes. Le matériau semi-conducteur est dopé et la couche 103 est conforme. Cette couche conforme dopée 103 recouvre à la fois la couche diélectrique restante 101 et la couche sacrificielle 102 déposée précédemment. Le matériau semi-conducteur peut être du silicium dopé au bore par exemple avec une concentration d'environ $10^{19}$ at/cm$^3$. L'épaisseur de cette couche conforme dopée 103 peut être comprise entre environ 100 nanomètres et 1 micromètre par exemple.

Il y a ensuite une étape de gravure pour délimiter le contour extérieur du composant électromécanique vibrant. Cette étape n'est pas représentée et le contour extérieur du composant n'est pas illustré, car les figures ne montrent que la partie centrale du composant électromécanique vibrant.

On réalise un masque dur superficiel 104 de manière à protéger la couche conforme dopée 103 (figure 7E). Ce masque dur 104 comporte des ouvertures 105 correspondant à l'espacement entre l'élément mécanique et chaque future électrode. Elles correspondent aussi à l'espacement entre la future électrode souple et son support. Le masque dur 104 peut être de l'oxyde de silicium par exemple. Son épaisseur peut être comprise entre 50 et 150 nanomètres par exemple. Les ouvertures 105 peuvent être réalisées par photolithographie par faisceau électronique (e beam) ou par photolithographie profonde aux ultraviolets (deep UV).

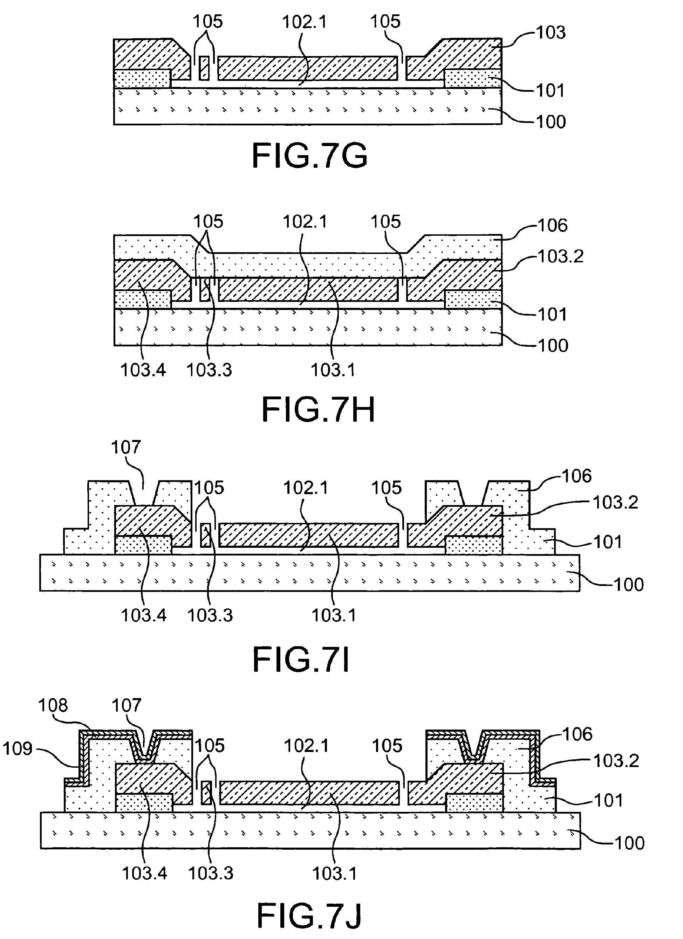

Par une nouvelle gravure à travers la couche active dopée 103, on approfondit les ouvertures 105 jusqu'à atteindre la couche sacrificielle 102. Cette gravure peut être une gravure plasma (figure 7F). L'étape suivante est une élimination de la couche sacrificielle 102 (figure 7G). Cette élimination peut être une gravure par plasma. Cette élimination libère la zone active. Une autre partie de électrode rigide n'est pas libérée ainsi que le support pour l'électrode souple, ils reposent sur la couche diélectrique 101. Sur cette figure on référencé par 103.1 l'élément mécanique vibrant, par 103.2 l'électrode fixe et par 103.3 l'électrode souple et par 103.4 son support.

De plus, on ôte le masque dur 104. Le vide correspondant au retrait de la couche sacrificielle 102 sous la zone active est référencé 102.1.

On va ensuite former, par exemple par PECVD (acronyme de plasma enhanced chemical vapor deposition soit dépôt chimique en phase vapeur en présence d'un plasma) une couche superficielle de protection 106, par exemple en oxyde de silicium au dessus de la couche conforme dopée 103. Cette couche de protection 106 est une couche conforme, elle ne pénètre pas dans les ouvertures 105 (figure 7H). Cette couche de protection 106 s'étend sur la zone active et autour d'elle et atteint même le substrat 100 au-delà de la couche conforme dopée 103. Cette couche de protection 106 est ensuite gravée, on l'ôte uniquement sur la zone active du composant électromécanique mais pas sur le reste du composant électromécanique. La figure 7I ne montre que la partie gauche du composant électromécanique vibrant et on ne voit plus l'électrode rigide.

On définit dans la couche de protection conforme 106, des ouvertures 107 qui atteignent l'électrode souple et l'électrode rigide en dehors de la zone active. Ces ouvertures 107 vont servir à faire de plots de contacts électriques sur les électrodes. La figure 7I ne montre qu'une ouverture 107 au niveau du support de l'électrode souple. Il n'est pas difficile d'imaginer la même chose du côté de l'électrode rigide.

On réalise ces plots de contacts électriques 108 dans les ouvertures 107 et des pistes conductrices 109 qui les prolongent (figure 7J). Ces plots de contacts électriques 108 et ces pistes 109 peuvent être réalisés par exemple par un bicouche d'un siliciure de métal tel que le siliciure de nickel NiSi et d'un alliage aluminium/cuivre AlCu.

Bien qu'un certain mode de réalisation de la présente invention ait été représenté et décrit de façon détaillée, on comprendra que différents changements et modifications puissent être apportés sans sortir du cadre de l'invention.

**DOCUMENTS CITÉS**

[1] "Q-optimized lateral free-free beam micromechanical resonators", W. T. Hsu, J. R. Clark and C. T. C. Nguyen, Digest of Technical Papers, the 11th Int. Conf. on Solid-State Sensors and Actuators (Transducers' 01) Munich, Germany, June 10-14, 2001, pages 1110-1113.

[2] "Third-order intermodulation distorsion in capacitively - driven CC - beam micromechanical resonators" Navid, R.; Clarck, J.R.; Demirci, .; Nguyen, C.T.-C., Micro Electro Mechanical System, 2001, MEMS 2001, the 14th IEEE International Conference on Volume, Issue, 2001 Pages: 228-231.

[3] "1.51 GHz nanocrystalline diamond micromechanical disk resonator with material mismatched isolating support", J. Wang, J.E. Poutler, T. Feygelsen and C.T.C. Nguyen, Proceedings, 17 th Int. IEEE MEMS Conf., Maastricht, The Netherlands, Jan 25-29 2004, pages 641-644.

[4] « Thèse de doctorat en sciences des matériaux » de Dimitri Galayko, 6 décembre 2002 Lille 1, 2002.

[5] "Measurement techniques for capacitively transduced VHF to UHF micromechanical resonator" J. R. Clark, W. T. Hsu, C. T. C. Nguyen Digest of Technical Papers, the 11th Int. Conf. on Solid-State Sensors and Actuators (Transducers' 01) Munich, Germany, June 10-14, 2001, pages 1118-1121.

## Revendications

1. Composant électromécanique vibrant à l'échelle nanométrique ou micrométrique comportant un élément mécanique vibrant (1) qui coopère avec au moins une électrode dite de détection (2), **caractérisé en ce que** l'électrode de détection (2) est souple et est destinée à vibrer en opposition de phase par rapport à l'élément mécanique vibrant (1).

2. Composant électromécanique vibrant selon la revendication 1, comportant en outre au moins une électrode d'actionnement (3) qui coopère avec l'élément mécanique vibrant (1).

3. Composant électromécanique selon la revendication 2, dans lequel l'électrode d'actionnement (3) est confondue avec l'électrode de détection (2).

4. Composant électromécanique vibrant selon la revendication 2, dans lequel, les électrodes d'actionnement (3) et de détection (2) sont situées face à face de part et d'autre de l'élément mécanique vibrant (1).

5. Composant électromécanique vibrant selon l'une des revendications précédentes, dans lequel lorsque le composant électromécanique comporte plusieurs électrodes souples (2), elles sont placées face à un ventre de vibration d'au moins un mode de vibration de l'élément mécanique vibrant (1).

6. Composant électromécanique vibrant selon l'une des revendications précédentes, dans lequel il y a plusieurs électrodes souples (2), l'une au moins vibre sur un mode harmonique de l'élément mécanique vibrant, au moins une autre vibrant sur un autre mode harmonique ou sur le mode fondamental de l'élément mécanique vibrant (1).

7. Composant électromécanique vibrant selon l'une des revendications précédentes, dans lequel l'électrode souple (2) est une poutre fonctionnant en flexion.

8. Composant électromécanique vibrant selon l'une des revendications précédentes, dans lequel l'élément mécanique vibrant (1) est une poutre fonctionnant en flexion.

9. Composant électromécanique vibrant selon la revendication 8, dans lequel la poutre est ancrée à ses extrémités ou dans sa partie médiane.

10. Composant électromécanique vibrant selon l'une des revendications 1 à 7, dans lequel l'élément mécanique vibrant est un disque à mode elliptique ou une plaque polygonale de Lamé.

11. Composant électromécanique vibrant selon les revendications 7 et 8, dans lequel l'électrode souple (2) a une longueur inférieure ou égale à celle de l'élément mécanique vibrant (1).

12. Composant électromécanique vibrant selon l'une des revendications précédentes, dans lequel l'élément mécanique vibrant (1) a une rigidité mécanique sensiblement égale à celle de l'électrode souple (2).

13. Composant électromécanique vibrant selon l'une des revendications précédentes, **caractérisé en ce que** c'est un résonateur ou un capteur de mouvement.

14. Procédé de réalisation d'un composant électromécanique vibrant à l'échelle nanométrique ou micrométrique comportant un élément mécanique vibrant qui coopère avec au moins une électrode dite de détection qui est souple et est destinée à vibrer en opposition de phase par rapport à l'élément mécanique vibrant, comportant les étapes suivantes :

a) formation sur un substrat (100) de matériau semi-conducteur d'un caisson (120) limité par du matériau diélectrique (101) au contour d'une zone active englobant en partie l'élément mécanique vibrant et l'électrode souple,

b) remplissage du caisson (120) d'un matériau sacrificiel (102), puis d'un matériau semi-conducteur dopé (103) qui déborde hors du caisson pour former l'élément mécanique vibrant et l'électrode souple,

c) gravure d'au moins une ouverture (105) dans le matériau semi-conducteur (103) atteignant le matériau sacrificiel (102) pour former un espacement entre l'élément mécanique vibrant et l'électrode souple et délimiter l'électrode souple (103.2) d'un support (103.4) de l'électrode souple,

d) élimination du matériau sacrificiel (102) par l'ouverture (105),

e) couverture par un matériau de protection (104) du composant électromécanique à l'exception de la zone active,

f) réalisation d'au moins un plot de contact électrique (108) sur l'électrode souple en dehors de la zone active à travers le matériau de protection (106).

15. Procédé de réalisation selon l'une des revendications 14, dans lequel le composant électromécanique comporte au moins une autre électrode rigide, la zone active englobant en partie l'électrode rigide, le matériau semi-conducteur remplissant le caisson et débordant hors du caisson réalisant l'électrode rigide à l'étape b), une ouverture dans le matériau semi-conducteur étant réalisée pour former un espacement entre l'électrode rigide et l'élément mécanique vibrant à l'étape c), un contact électrique étant réalisé sur l'électrique rigide en dehors de la zone active à travers le matériau de protection à l'étape f).

## Claims

1. Vibrating nano-scale or micro-scale electromechanical component comprising a vibrating mechanical element (1) which cooperates with at least one so-called detection electrode (2), **characterised in that** the detection electrode (2) is flexible and is intended to vibrate in phase opposition relative to the vibrating mechanical element (1).

2. Vibrating electromechanical component of claim 1, further comprising at least one actuating electrode (3), which cooperates with the vibrating mechanical element (1).

3. Electromechanical component of claim 2, wherein the actuating electrode (3) is merged with the detection electrode (2).

4. Vibrating electromechanical component of claim 2, wherein the actuating (3) and detection (2) electrodes are situated face-to-face on either side of the vibrating mechanical element (1).

5. Vibrating electromechanical component as claimed in one of the preceding claims, wherein, when the electromechanical element comprises several flexible electrodes (2), they are placed apposite an antinode of at least one mode of vibration of the vibrating mechanical element (1).

6. Vibrating electromechanical component as claimed in one of the preceding claims, wherein there are several flexible electrodes (2); at least one vibrates in a harmonic mode of the vibrating mechanical element, at least one other vibrating in another harmonic mode or in the dominant mode of the vibrating mechanical element (1).

7. Vibrating electromechanical component as claimed in one of the preceding claims, wherein the flexible electrode (2) is a beam operating in flex-mode.

8. Vibrating electromechanical component as claimed in one of the preceding claims, wherein the vibrating mechanical element (1) is a beam operating in flex-mode.

9. Vibrating electromechanical component of claim 8, wherein the beam is anchored at the ends thereof or in the middle portion thereof.

10. Vibrating electromechanical component as claimed in one of claims 1 to 7, wherein the vibrating mechanical element is an elliptical mode disk or a Lamé polygonal plate.

11. Vibrating electromechanical component as claimed in claims 7 and 8, wherein the flexible electrode (2) has a length less than or equal to that of the vibrating mechanical element (1).

12. Vibrating electromechanical component as claimed in one of the preceding claims, wherein the vibrating mechanical element (1) has a degree of mechanical rigidity substantially equal to that of the flexible electrode (2).

13. Vibrating electromechanical component as claimed in one of the preceding claims, **characterised in that** it is a resonator or motion sensor.

14. Method of producing a vibrating nano-scale or micro-scale electromechanical component comprising a vibrating mechanical element, which cooperates with at least one so-called detection electrode, which is flexible and is intended to vibrate in phase opposition relative to the vibrating mechanical element, comprising the following steps:

a) formation of compartment (120) on a substrate (100) of semiconductor material, which is bounded by dielectric material (101) around the contour of an active region partially enclosing the vibrating mechanical element and the flexible electrode,
b) filling the compartment (120) with a sacrificial material (102) and then with a doped semiconductor material (103) which overflows from the compartment to form the vibrating mechanical element and the flexible electrode,
c) etching at least one opening (105) in the semiconductor material (103) preaching as far as the sacrificial material (102) in order to form a space between the mechanical vibrating element and the flexible electrode and to define the flexible electrode (103.2) of a flexible electrode support (103.4),
d) removal of the sacrificial material (102) via the opening (105),
e) covering the electromechanical component with a protective material (104), except for the active region,
f) producing at least one electrical contact pad (108) on the flexible electrode, through the protective material (106), and outside of the active region.

15. Production method of claim 14, wherein the electromechanical component comprises at least one other rigid electrode, the active region partially enclosing the rigid electrode, the semiconductor material filling the compartment and overflowing from the compartment, thereby producing the rigid electrode in step b), an opening in the semiconductor material being made in order to form a space between the rigid electrode and the vibrating mechanical element in step c), and, in step f), an electrical contact being produced through the protective material on the rigid electric outside of the active region.

**Patentansprüche**

1. Schwingendes elektromechanisches Bauelement im nanometrischen oder mikrometrischen Maßstab, umfassend ein schwingendes mechanisches Element (1), das mit mindestens einer sogenannten Erkennungselektrode (2) zusammenwirkt, **dadurch gekennzeichnet, dass** die Erkennungselektrode (2) flexibel ist und dazu bestimmt ist, in Gegenphase zum schwingenden mechanischen Element (1) zu schwingen.

2. Schwingendes elektromechanisches Bauelement nach Anspruch 1, außerdem umfassend mindestens eine Aktivierungselektrode (3), die mit dem schwingenden mechanischen Element (1) zusammenwirkt.

3. Schwingendes elektromechanisches Bauelement nach Anspruch 2, wobei die Aktivierungselektrode (3) mit der Erkennungselektrode (2) vereinigt ist.

4. Schwingendes elektromechanisches Bauelement nach Anspruch 2, wobei die Aktivierungs- (3) und die Erkennungselektrode (2) sich einander beiderseits des schwingenden mechanischen Elements (1) gegenüberliegen.

5. Schwingendes elektromechanisches Bauelement nach einem der vorherigen Ansprüche, wobei, wenn das elektromechanische Bauelement mehrere flexible Elektroden (2) umfasst, diese einem Schwingungsbauch mindestens einer Schwingungsform des schwingenden elektromechanischen Bauelements (1) gegenüber angeordnet sind.

6. Schwingendes elektromechanisches Bauelement nach einem der vorherigen Ansprüche, wobei mehrere flexible Elektroden (2) vorhanden sind, mindestens eine bei einer harmonischen Schwingungsform des schwingenden elektromechanischen Bauelements (1) schwingt und mindestens eine andere bei einer anderen harmonischen Schwingungsform oder bei der Grundschwingungsform des schwingenden elektromechanischen Bauelements (1) schwingt.

7. Schwingendes elektromechanisches Bauelement nach einem der vorherigen Ansprüche, wobei die flexible Elektrode (2) ein sich verbiegender Balken ist.

8. Schwingendes elektromechanisches Bauelement nach einem der vorherigen Ansprüche, wobei das schwingende mechanische Element (1) ein sich verbiegender Balken ist.

9. Schwingendes elektromechanisches Bauelement nach Anspruch 8, wobei der Balken an seinen Enden oder in seinem Mittelteil verankert ist.

10. Schwingendes elektromechanisches Bauelement nach einem der Ansprüche 1 bis 7, wobei das schwingende mechanische Element eine Scheibe mit elliptischer Schwingungsform oder eine vieleckige Laméplatte ist.

11. Schwingendes elektromechanisches Bauelement nach den Ansprüchen 7 und 8, wobei die flexible Elektrode (2) eine Länge kleiner oder gleich der des schwingenden mechanischen Elements (1) aufweist.

12. Schwingendes elektromechanisches Bauelement nach einem der vorherigen Ansprüche, wobei das schwingende mechanische Element (1) eine mechanische Steifigkeit hat, die im Wesentlichen der der flexiblen Elektrode (2) entspricht.

13. Schwingendes elektromechanisches Bauelement nach einem der vorherigen Ansprüche, **dadurch gekennzeichnet, dass** es ein Resonator oder ein Bewegungssensor ist.

14. Verfahren zur Herstellung eines schwingenden elektromechanischen Bauelements im nanometrischen oder mikrometrischen Maßstab, umfassend ein schwingendes mechanisches Element, das mit mindestens einer sogenannten Erkennungselektrode zusammenwirkt, die flexibel ist und dazu bestimmt ist, in Gegenphase zum schwingenden mechanischen Element zu schwingen, umfassend die folgenden Schritte:

a) das Formen, auf einem Substrat (100) aus Halbleitermaterial, eines Kastens (120), der durch dielektrisches Material am Umriss einer aktiven Zone begrenzt wird, die das schwingende mechanische Element und die flexible Elektrode zum Teil umschließt,
b) das Füllen des Kastens (120) mit einem Opfermaterial (102), dann mit einem dotierten Halbleitermaterial (103), das aus dem Kasten austritt, um das schwingende mechanische Element und die flexible Elektrode zu formen,
c) das Ätzen mindestens einer Öffnung (105) im Halbleitermaterial (103), die das Opfermaterial (102) erreicht, um zwischen dem schwingenden mechanischen Element und der flexiblen Elektrode einen Zwischenraum zu formen und die flexible Elektrode (103.2) von einem Träger der flexiblen Elektrode (103.3) abzugrenzen,
d) das Entfernen des Opfermaterials (102) durch die Öffnung (105),
e) das Bedecken des elektromechanischen Bauelements mit Ausnahme der aktiven Zone mit einem Schutzmaterial (104),
f) das Realisieren mindestens eines elektrischen Kontaktstücks (108) auf der flexiblen Elektrode außerhalb der aktiven Zone durch das Schutzmaterial (106) hindurch.

15. Herstellungsverfahren nach Anspruch 14, wobei das elektromechanische Bauelement mindestens eine andere starre Elektrode umfasst, die aktive Zone die starre Elektrode zum Teil umschließt, in Schritt b) aus dem Halbleitermaterial, mit welchem der Kasten gefüllt ist und das aus dem Kasten austritt, die starre Elektrode geformt wird, in Schritt c) eine Öffnung im Halbleitermaterial hergestellt wird, um zwischen der starren Elektrode und dem schwingenden mechanischen Element einen Zwischenraum zu formen, in Schritt f) ein elektrischer Kontakt auf der starren Elektrode außerhalb der aktiven Zone durch das Schutzmaterial hindurch hergestellt wird.

FIG.1

EP 2 201 681 B1

FIG.2

FIG.3A

FIG.3B

FIG.4A

FIG.4B

FIG.5A

FIG.5B

FIG.6A

FIG.6B

FIG.6C

FIG.7A

101
100

FIG.7B

120

101
100

FIG.7C

120

102
101
100

FIG.7D

103
102
101
100

FIG.7E

105          105

105
103
102
101
100

FIG.7F

105          105

105
103
101
100

105  102.1  105  103

## FIG.7G

105  102.1  105  106
103.2
101
100

103.4  103.3  103.1

## FIG.7H

107  105  102.1  105  106
103.2
101
100

103.4  103.3  103.1

## FIG.7I

108  107  105  102.1  105  106
109  103.2
101
100

103.4  103.3  103.1

## FIG.7J

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2872501

**Littérature non-brevet citée dans la description**

- **W. T. Hsu ; J. R. Clark ; C. T. C. Nguyen.** Q-optimized lateral free-free beam micromechanical resonators. *Digest of Technical Papers, the 11th Int. Conf. on Solid-State Sensors and Actuators (Transducers' 01) Munich, Germany,* 10 Juin 2001, 1110-1113
- **Navid, R. ; Clarck, J.R. ; Demirci ; Nguyen, C.T.-C.** Third-order intermodulation distorsion in capacitively - driven CC - beam micromechanical resonators. *Micro Electro Mechanical System, 2001, MEMS 2001, the 14th IEEE International Conference on Volume,* 2001, 228-231

- **J. Wang ; J.E. Poutler ; T. Feygelsen ; C.T.C. Nguyen.** 1.51 GHz nanocrystalline diamond micromechanical disk resonator with material mismatched isolating support. *Proceedings, 17 th Int. IEEE MEMS Conf., Maastricht, The Netherlands,* 25 Janvier 2004, 641-644
- **Dimitri Galayko.** *Thèse de doctorat en sciences des matériaux,* 06 Décembre 2002
- **J. R. Clark ; W. T. Hsu ; C. T. C. Nguyen.** Measurement techniques for capacitively transduced VHF to UHF micromechanical resonator. *Digest of Technical Papers, the 11th Int. Conf. on Solid-State Sensors and Actuators (Transducers' 01) Munich, Germany,* 10 Juin 2001, 1118-1121